# EUROPEAN PATENT APPLICATION

(11) **EP 4 654 072 A1**
(43) Date of publication of application: **26.11.2025**
(21) Application number: 23922369.6
(22) Date of filing: 01.11.2023
(51) Int. Cl.: G06F 30/394, G06F 30/396, G06F 1/04, G06F 1/12

(54) **CHIPLET AND ELECTRONIC DEVICE**

(30) Priority: 17.02.2023 CN 202310188683
(71) Applicant: Huawei Technologies Co., Ltd., Shenzhen, Guangdong 518129 (CN)
(72) Inventor: ZHOU, Zhaoliu, Shenzhen, Guangdong 518129 (CN); CHEN, Zanfeng, Shenzhen, Guangdong 518129 (CN); WAN, Zhenxing, Shenzhen, Guangdong 518129 (CN); ZENG, Qiuling, Shenzhen, Guangdong 518129 (CN); ZHANG, Bin, Shenzhen, Guangdong 518129 (CN)
(74) Representative: Pfenning, Meinig & Partner mbB
(86) International application number: PCT/CN2023/129179
(87) International publication number: WO 2024/169253

(57) **Abstract**

This application relates to a chiplet and an electronic device, and relates to the circuit field. The chiplet includes a first die, a second die, a first clock mesh, and a second clock mesh. A first clock circuit in the first die includes a first clock generation circuit and a first drive buffer circuit. A second clock circuit in the second die includes a second drive buffer circuit. An input end of the first drive buffer circuit is coupled to a first output end of the first clock generation circuit, and a first output end of the first drive buffer circuit is coupled to an input end of the first clock mesh. An input end of the second drive buffer circuit is coupled to a second output end of the first clock generation circuit, and a first output end of the second drive buffer circuit is coupled to an input end of the second clock mesh. The first die and the second die share a first clock signal of the first clock generation circuit, so that clock signals of the first clock mesh and the second clock mesh are synchronized. This resolves a problem of a large clock delay.

## Description

This application claims priority to Chinese Patent Application No. 202310188683.7, filed with the China National Intellectual Property Administration on February 17, 2023 and entitled "CHIPLET AND ELECTRONIC DEVICE", which is incorporated herein by reference in its entirety.

### TECHNICAL FIELD

Embodiments of this application relate to the circuit field, and in particular, to a chiplet and an electronic device.

### BACKGROUND

With continuous development of semiconductor manufacturing processes, sizes of transistors are approaching a physical limit, resulting in an increasingly long time and increasingly high costs of chip design, increasingly limited effect, and increasingly slow Moore's Law. A chiplet (chiplet) is expected to become a component that staves off the decline of Moore's Law, shortens a process time, and supports continuous development of the semiconductor industry. In a multi-die (die) module of the chiplet, smaller dies are interconnected through a die-to-die (die-to-die) physical layer (physical, PHY) intellectual property core (intellectual property core, IP) interface. However, there is a large clock delay between the dies.

### SUMMARY

Embodiments of this application provide a chiplet and an electronic device, to resolve a problem of a large clock delay between dies in the conventional technology.

To achieve the foregoing objectives, the following technical solutions are used in embodiments of this application.

According to a first aspect, a chiplet is provided. The chiplet includes a first die, a second die, a first clock mesh, and a second clock mesh. The first die includes a first clock circuit, and the first clock circuit includes a first clock generation circuit and a first drive buffer circuit. The second die includes a second clock circuit, and the second clock circuit includes a second drive buffer circuit, where an input end of the first drive buffer circuit is coupled to a first output end of the first clock generation circuit, and a first output end of the first drive buffer circuit is coupled to an input end of the first clock mesh. An input end of the second drive buffer circuit is coupled to a second output end of the first clock generation circuit, and a first output end of the second drive buffer circuit is coupled to an input end of the second clock mesh.

In the foregoing technical solution, the input end of the first drive buffer circuit is coupled to the first output end of the first clock generation circuit, and the input end of the second drive buffer circuit is coupled to the second output end of the first clock generation circuit, so that the first die and the second die can share a first clock signal of the first clock generation circuit, and clock signals of the first die and the second die are synchronized and clock signals of the first clock mesh and the second clock mesh are synchronized. This can resolve a problem of a large clock delay due to clock asynchronization between dies and can reduce interconnection power consumption, without crossing clock domains.

In a possible implementation of the first aspect, the first clock generation circuit includes a first phase-locked loop and a first multiplexer, and the second clock circuit further includes a second clock generation circuit, where the second clock generation circuit includes a second phase-locked loop and a second multiplexer. A first input end and a second input end of the first multiplexer are coupled to a first output end of the first phase-locked loop and a second output end of the second phase-locked loop respectively, and an output end of the first multiplexer is coupled to the input end of the first drive buffer circuit. A first input end and a second input end of the second multiplexer are coupled to a first output end of the second phase-locked loop and a second output end of the first phase-locked loop respectively, and an output end of the second multiplexer is coupled to the input end of the second drive buffer circuit. In the possible implementation, the second phase-locked loop, the first multiplexer, and the second multiplexer are disposed, so that different dies can be used as master dies to output clock source signals. This can be used in more scenarios, to enrich functions of the chiplet. In addition, a length of a signal transmission path between the first output end of the first phase-locked loop and the first input end of the first multiplexer is equal to a length of a signal transmission path between the second output end of the first phase-locked loop and the second input end of the second multiplexer, so that clock signals of the first die and the second die are synchronized. This can resolve a problem of a large clock delay due to clock asynchronization between dies and can further reduce interconnection power consumption, without crossing clock domains.

In a possible implementation of the first aspect, the chiplet further includes a silicon interposer, and the first clock mesh and the second clock mesh are disposed in the silicon interposer and are connected to each other via the silicon interposer. The silicon interposer is further configured to connect the first clock circuit to the second clock circuit. In the possible implementation, the first clock mesh and the second clock mesh are connected to each other via the silicon interposer, and the first clock circuit and the second clock circuit are connected to each other via the silicon interposer, so that a plurality of clock domains of a plurality of dies are unified into a same clock domain, to implement global clock synchronization. This resolves problems of a large clock delay and high power consumption due to clock asynchronization between cross-clock dies.

In a possible implementation of the first aspect, the chiplet further includes a silicon interposer, the first clock mesh is disposed in the first die, the second clock mesh is disposed in the second die, and the first clock mesh and the second clock mesh are connected to each other via the silicon interposer. The silicon interposer is further configured to connect the first clock circuit to the second clock circuit. In the possible implementation, the first clock mesh and the second clock mesh are connected to each other via the silicon interposer, and the first clock circuit and the second clock circuit are connected to each other via the silicon interposer, so that a plurality of clock domains of a plurality of dies are unified into a same clock domain, to implement global clock synchronization. This resolves problems of a large clock delay and high power consumption due to clock asynchronization between cross-clock dies.

In a possible implementation of the first aspect, the first die and the second die are located on a same wafer. In the possible implementation, the first die and the second die are placed on the same wafer. This resolves problems of a large clock delay and high power consumption due to clock asynchronization between cross-clock dies.

In a possible implementation of the first aspect, the chiplet further includes a first sealing ring, a second sealing ring, and a dicing groove, the first sealing ring is disposed between the first die and the dicing groove, and the second sealing ring is disposed between the second die and the dicing groove. In the possible implementation, the dicing groove, the first sealing ring, and the second sealing ring are disposed, so that the first die and the second die can be flexibly cut or spliced, and the first clock mesh and the second clock mesh can be flexibly cut or spliced. In this way, one large clock mesh can be cut into a plurality of separate small clock meshes, to support a flexible architecture of the chiplet, and improve interconnection competitiveness of the chiplet.

In a possible implementation of the first aspect, the first die is grown on the silicon interposer, or the first die is bonded to the silicon interposer via a micro bump; and/or the second die is grown on the silicon interposer, or the second die is bonded to the silicon interposer via a micro bump. In the possible implementation, the die is grown on the silicon interposer, or the die is bonded to the silicon interposer via the micro bump, to form a complete clock system, so that a plurality of clock domains of a plurality of dies are unified into a same clock domain, to implement global clock synchronization. This resolves problems of a large clock delay and high power consumption due to clock asynchronization between cross-clock dies.

In a possible implementation of the first aspect, the first die and the second die are of a heterostructure. In the possible implementation, a chiplet including a heterostructure can be used, has diverse application scenarios, and can resolve problems of a large clock delay and high power consumption due to clock asynchronization between cross-clock dies.

In a possible implementation of the first aspect, either the first clock circuit or the second clock circuit further includes a phase adjustment circuit. A first input end of the phase adjustment circuit is coupled to a second output end of the drive buffer circuit that is located on the same die as the clock circuit. A second input end of the phase adjustment circuit is coupled to an output end of the first clock generation circuit. An output end of the phase adjustment circuit is coupled to the input end of the drive buffer circuit that is located on the same die as the clock circuit. A third input end of the phase adjustment circuit of the first clock circuit is coupled to a second output end of the drive buffer circuit of the second clock circuit, and/or a third input end of the phase adjustment circuit of the second clock circuit is coupled to a second output end of the drive buffer circuit of the first clock circuit. When the first clock circuit and the second clock circuit are of a heterostructure, and when a clock signal is transmitted in the first clock circuit and a clock signal is transmitted in the second clock circuit, phases of the two clock signals may change. In the possible implementation, the phase adjustment circuit is disposed, to adjust a second clock signal of the first clock circuit and/or a second clock signal of the second clock circuit in time, so that clock signals received by the first clock mesh and the second clock mesh are the same in phase. In this way, the clock signals of the first die and the second die are synchronized, and the clock signals of the first clock mesh and the second clock mesh are synchronized. This can resolve a problem of a large clock delay due to clock asynchronization between dies and can further reduce interconnection power consumption, without crossing clock domains.

In a possible implementation of the first aspect, the phase adjustment circuit includes a phase detector, a phase alignment circuit, and a phase interpolator. A first input end of the phase detector is coupled to the second output end of the drive buffer circuit that is located on the same die as the clock circuit. An output end of the phase detector is coupled to an input end of the phase alignment circuit. A first input end of the phase interpolator is coupled to an output end of the phase alignment circuit. A second input end of the phase interpolator is coupled to the output end of the first clock generation circuit. An output end of the phase interpolator is coupled to the input end of the drive buffer circuit that is located on the same die as the clock circuit. A second input end of the phase detector of the first clock circuit is coupled to the second output end of the drive buffer circuit of the second clock circuit, and/or a second input end of the phase detector of the second clock circuit is coupled to the second output end of the drive buffer circuit of the first clock circuit. When the first clock circuit and the second clock circuit are of a heterostructure, and when a clock signal is transmitted in the first clock circuit and a clock signal is transmitted in the second clock circuit, phases of the two clock signals may change. In the possible implementation, the phase detector, the phase alignment circuit, and the phase interpolator are disposed, to adjust a second clock signal of the first clock circuit and/or a second clock signal of the second clock circuit in time, so that clock signals received by the first clock mesh and the second clock mesh are the same in phase. In this way, the clock signals of the first die and the second die are synchronized, and the clock signals of the first clock mesh and the second clock mesh are synchronized. This can resolve a problem of a large clock delay due to clock asynchronization between dies and can further reduce interconnection power consumption, without crossing clock domains.

In a possible implementation of the first aspect, the first clock generation circuit is further configured to receive a reference clock signal. In the possible implementation, to avoid large clock jitters of phases of the first clock signal output by the first phase-locked loop and the first clock signal output by the second phase-locked loop, a reference clock is coupled between the first phase-locked loop and the second phase-locked loop, and the first phase-locked loop receives the reference clock signal, to adjust the phase of the first clock signal to be the same as a phase of the first clock signal of the second phase-locked loop.

In a possible implementation of the first aspect, the first clock mesh and the second clock mesh each include routing in a first direction and routing in a second direction, where the first direction and the second direction are perpendicular to each other. The routing of the first clock mesh in the first direction is aligned with the routing of the second clock mesh in the first direction; or the routing of the first clock mesh in the second direction is aligned with the routing of the second clock mesh in the second direction. In the possible implementation, routing of the first clock mesh and the second clock mesh in the first direction or the second direction is aligned, so that the first clock mesh and the second clock mesh can be spliced. In this way, a clock mesh with a size greater than that of a single photolithography mask can be implemented, a plurality of dies on one wafer can be spliced into a large die with a physical size greater than that of the mask, allowing for a system on wafer (system on wafer, SOW) design or a wafer scale engine (wafer scale engine, WSE) design. In addition, a plurality of clock meshes are spliced into a same clock mesh, so that a plurality of clock domains of a plurality of dies are unified into a same clock domain, to implement global clock synchronization. This resolves problems of a large clock delay and high power consumption due to clock asynchronization between cross-clock dies.

In a possible implementation of the first aspect, the first drive buffer circuit has a symmetrical structure, and a structure of the second drive buffer circuit is symmetrical with the structure of the first drive buffer circuit; and/or the first clock mesh has a symmetrical structure, and the structure of the first clock mesh is symmetrical with a structure of the second clock mesh. In the possible implementation, the first drive buffer circuit has the symmetric structure, so that signal transmission paths of a plurality of clock signals passing through the first drive buffer circuit have a same length, and the plurality of clock signals transmitted to the first clock mesh have a same phase. The structure of the second drive buffer circuit is symmetrical with the structure of the first drive buffer circuit, so that the signal transmission paths of the plurality of clock signals passing through the first drive buffer circuit have the same length as signal transmission paths of a plurality of clock signals passing through the second drive buffer circuit, and the plurality of clock signals transmitted to the first clock mesh have the same phase as the plurality of clock signals transmitted to the second clock mesh. This can resolve a problem of a large clock delay due to clock asynchronization between the dies. In addition, the clock signals of the first die and the second die are synchronized, and the clock signals of the first clock mesh and the second clock mesh are synchronized. This can reduce interconnection power consumption without crossing the clock domains. In addition, the first clock mesh has the symmetric structure, and the structure of the first clock mesh is symmetric with the structure of the second clock mesh, so that the first clock mesh can output a plurality of third clock signals with a same phase based on a plurality of received second clock signals, and the plurality of third clock signals output by the first clock mesh and a plurality of third clock signals output by the second clock mesh are the same in phase, to implement global clock synchronization. This can resolve a problem of a large clock delay due to clock asynchronization between dies and can reduce interconnection power consumption, without crossing clock domains.

In a possible implementation of the first aspect, the first drive buffer circuit includes at least two layers of cascaded drive buffers, and the first drive buffer circuit includes one input end and a plurality of output ends. In the possible implementation, signal attenuation occurs in the clock signal in the signal transmission path. In this embodiment of this application, the drive buffer is used to relay and shape the clock signal, to avoid clock waveform attenuation, and further maintain integrity of a clock signal waveform and normal propagation of the clock signal. In addition, the first drive buffer circuit includes structures of the at least two layers of cascaded drive buffers, and the first drive buffer circuit includes one input end and a plurality of output ends, so that when a small quantity of drive buffers are used, the first clock signal can be maintained, and one first clock signal can be converted into a plurality of second clock signals for output.

According to a second aspect, an electronic device is provided. The electronic device includes the chip let in the first aspect and the possible implementations of the first aspect. For beneficial effect that can be achieved by the electronic device, refer to the beneficial effect of the chip let provided above, and details are not described herein again.

### BRIEF DESCRIPTION OF DRAWINGS

FIG. 1 is a diagram of interconnection between dies;
FIG. 2 is a diagram 1 of a structure of a chiplet according to an embodiment of this application;
FIG. 3 is a diagram 2 of a structure of a chiplet according to an embodiment of this application;
FIG. 4 is a diagram 1 of a clock mesh according to an embodiment of this application;
FIG. 5 is a diagram 3 of a structure of a chiplet according to an embodiment of this application;
FIG. 6 is a diagram 4 of a structure of a chiplet according to an embodiment of this application;
FIG. 7 is a diagram 5 of a structure of a chiplet according to an embodiment of this application;
FIG. 8 is a diagram 2 of a clock mesh according to an embodiment of this application;
FIG. 9 is a diagram of a position at which a chiplet is cut according to an embodiment of this application;
FIG. 10 is a diagram 6 of a structure of a chiplet according to an embodiment of this application;
FIG. 11 is a diagram 7 of a structure of a chiplet according to an embodiment of this application;
FIG. 12 is a diagram 8 of a structure of a chiplet according to an embodiment of this application;
FIG. 13 is a diagram 9 of a structure of a chiplet according to an embodiment of this application;
FIG. 14 is a diagram 10 of a structure of a chiplet according to an embodiment of this application;
FIG. 15 is a diagram 11 of a structure of a chiplet according to an embodiment of this application; and
FIG. 16 is a diagram 12 of a structure of a chiplet according to an embodiment of this application.

### DESCRIPTION OF EMBODIMENTS

The following further describes the technical solutions of this disclosure in detail with reference to accompanying drawings and embodiments. Although example implementation methods of this disclosure are shown in the accompanying drawings, it should be understood that this disclosure may be implemented in various forms and should not be limited by implementations described herein. Instead, these implementations are provided to understand this disclosure more thoroughly and to fully convey the scope of this disclosure to a person skilled in the art.

In the following paragraphs, this disclosure is more specifically described with reference to accompanying drawings by using examples. The advantages and features of this disclosure will be clearer from the following descriptions and claims. It should be noted that the accompanying drawings are all in a very simplified form and a non-precise proportion, and are merely used to conveniently and clearly assist in describing objectives of embodiments of this disclosure.

In embodiments of this disclosure, the terms "first", "second", and the like are intended to distinguish between similar objects but do not necessarily indicate a specific order or sequence.

It should be noted that the technical solutions recorded in embodiments of this disclosure may be randomly combined if there is no conflict.

Before embodiments of this application are described, the related technical terms and background in embodiments of this application are described first.

A chiplet (chiplet) is a pre-manufactured chip that has a specific function and can be combined and integrated. In the chiplet, a plurality of dies (dies) are integrated through semiconductor manufacturing instead of pure package, to manufacture a chip for implementing a complex function. The chiplet can break through a bottleneck of photolithography area of a single chip and alleviate problems such as design cycle constraints. For example, the chiplet may include a wafer (wafer) disposed on a silicon interposer (interposer), and the wafer may include a plurality of dies.

An interconnection technology is one of most important technologies for the chiplet. Currently, in a 2.5-dimension (2.5 dimension, 2.5D) horizontal interconnection design, a physical layer (physical, PHY) intellectual property core (intellectual property core, IP) interface is mainly used as an interconnection interface. A clock solution in which a forward clock is combined with source synchronization or asynchronization is used between dies (die-to-die). This interconnection clock design has disadvantages such as a large die-to-die clock delay and high interconnection power consumption.

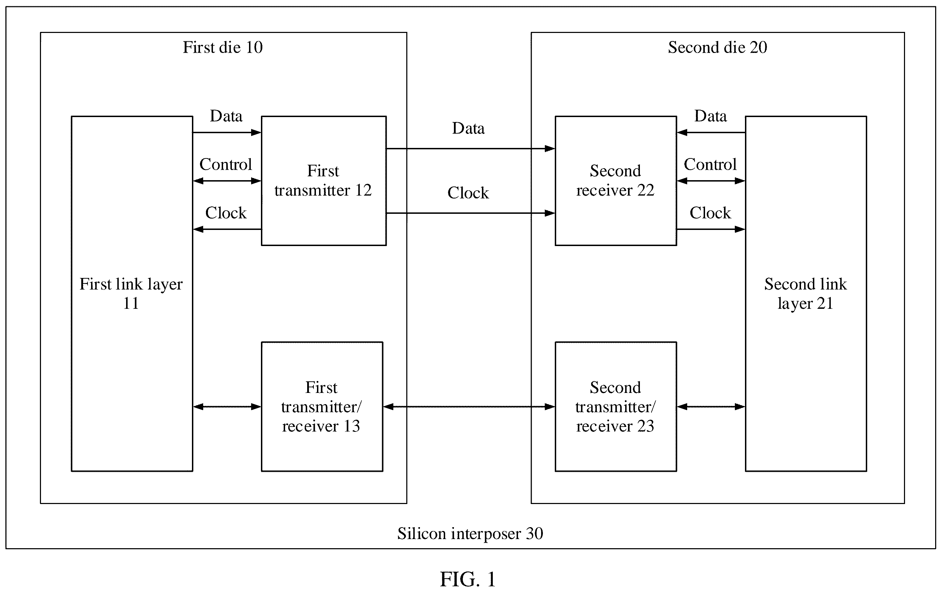

FIG. 1 is a diagram of interconnection between dies. The dies in a chiplet are interconnected via a PHY, and a forward clock is used as a die-to-die clock. Specifically, a first die 10 and a second die 20 are disposed in a silicon interposer 30. The first die 10 includes a first link layer 11 (link layer), a first transmitter 12 (tx slice), and a first transmitter/receiver 13 (tx/rx slices). The first link layer 11 is separately coupled to the first transmitter 12 and the first transmitter/receiver 13. The first transmitter 12 may be configured to send a clock signal and a control signal to the first link layer 11, and the first link layer 11 may be configured to send a data signal and a control signal to the first transmitter 12. The second die 20 includes a second link layer 21, a second receiver 22, and a second transmitter/receiver 23. The second link layer 21 is separately coupled to the second receiver 22 and the second transmitter/receiver 23. The second receiver 22 may be configured to send a clock signal and a control signal to the second link layer 21, and the second link layer 21 may be configured to send a data signal and a control signal to the second receiver 22. The first transmitter 12 is coupled to the second receiver 22, and the first transmitter/receiver 13 is coupled to the second transmitter/receiver 23. The first transmitter 12 may be configured to send a data signal and a clock signal to the second receiver 22.

The clock signal of the first transmitter 12 comes from a clock signal clk A generated by a phase-locked loop of the first die 10, and the first transmitter 12 may be configured to send the clock signal clk A to the second receiver 22. The second receiver 22 may be configured to sample the data signal based on the clock signal clk A, and send the sampled data signal to the second link layer 21. The clock signal of the second link layer 21 comes from a clock signal clk B generated by a phase-locked loop of the second die 20, and the second link layer 21 may be configured to receive, based on the clock signal clk B, the data signal sent by the second receiver 22. In this way, cross-clock-domain signal transmission between the first die 10 and the second die 20 is implemented.

In a process of data transmission between the first die 10 and the second die 20, conversion from a clock of the first die 10 to a clock of the second die 20 exists. Because there is a dynamic phase difference between the clock signal clk A and the clock signal clk B, in a process in which the second receiver 22 sends the sampled data signal to the second link layer 21 and the second link layer 21 receives the data signal sent by the second receiver 22, clock asynchronization needs to be performed, resulting in an additional delay. In addition, a cross-clock circuit also causes an increase in interconnection power consumption.

Different clocks are used by the two interconnected dies, and a design of die-to-die signal transmission synchronization cannot be implemented. In addition, as a quantity of interconnected dies increases, a die-to-die delay increases. A chip system in a multi-die splicing form has limited performance and high power consumption.

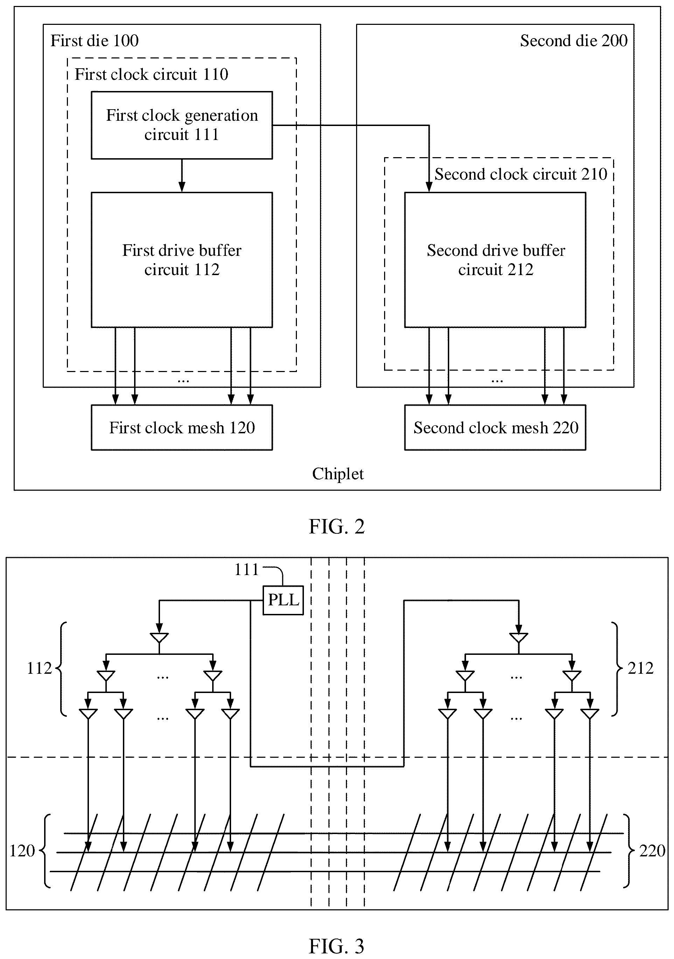

In view of this, an embodiment of this application provides a chiplet. FIG. 2 is a diagram 1 of a structure of a chiplet according to an embodiment of this application. The chiplet includes a first die 100, a second die 200, a first clock mesh 120, and a second clock mesh 220. The first die 100 includes a first clock circuit 110, and the first clock circuit 110 includes a first clock generation circuit 111 and a first drive buffer circuit 112. The second die 200 includes a second clock circuit 210, and the second clock circuit 210 includes a second drive buffer circuit 212. An input end of the first drive buffer circuit 112 is coupled to a first output end of the first clock generation circuit 111, and a first output end of the first drive buffer circuit 112 is coupled to an input end of the first clock mesh 120. An input end of the second drive buffer circuit 212 is coupled to a second output end of the first clock generation circuit 111, and a first output end of the second drive buffer circuit 212 is coupled to an input end of the second clock mesh 220.

The following briefly describes a circuit principle of this embodiment. The first clock generation circuit 111 is configured to output a first clock signal. The first drive buffer circuit 112 is configured to output a second clock signal based on the first clock signal, where the second clock signal may be obtained by maintaining the first clock signal. The first clock mesh 120 is configured to receive the second clock signal output by the first drive buffer circuit 112. The second drive buffer circuit 212 is configured to output the second clock signal based on the first clock signal. The second clock mesh 220 is configured to receive the second clock signal output by the second drive buffer circuit 212.

According to the chiplet provided in this embodiment of this application, the input end of the first drive buffer circuit 112 is coupled to the first output end of the first clock generation circuit 111, and the input end of the second drive buffer circuit 212 is coupled to the second output end of the first clock generation circuit 111, so that the first die 100 and the second die 200 can share the first clock signal of the first clock generation circuit 111, and clock signals of the first die 100 and the second die 200 are synchronized and clock signals of the first clock mesh 120 and the second clock mesh 220 are synchronized. This can resolve a problem of a large clock delay due to clock asynchronization between dies and can reduce interconnection power consumption, without crossing clock domains.

The chiplet may include a plurality of dies, and the plurality of dies include at least the first die 100 and the second die 200.

In addition, the first clock generation circuit 111 may include a phase-locked loop, and the first clock generation circuit 111 is configured to output the first clock signal via the phase-locked loop. The phase-locked loop (phase lock loop, PLL) may also be referred to as a phase-locked loop, and is configured to integrate all clock signals, so that a high-frequency device operates normally. The PLL may be an analog circuit placed inside the chiplet. A clock signal at an input end of the PLL may come from a clock generation circuit outside the chiplet, and is usually a crystal oscillator (which is referred to as a crystal oscillator for short). The first clock signal at an output end of the PLL is a clock source (clock source) signal of a clock mesh. The first clock signal output by the PLL is propagated to a clock pin of each sequential logic circuit inside the chiplet via the first drive buffer circuit 112 and the second drive buffer circuit 212, and is used as an input of each component of the chiplet.

In a possible implementation, the first drive buffer circuit 112 has a symmetrical structure, and a structure of the second drive buffer circuit 212 is symmetrical with the structure of the first drive buffer circuit 112. According to the chiplet provided in this embodiment of this application, the first drive buffer circuit 112 has the symmetric structure, so that signal transmission paths of a plurality of clock signals passing through the first drive buffer circuit 112 have a same length, and the plurality of clock signals transmitted to the first clock mesh 120 have a same phase. The structure of the second drive buffer circuit 212 is symmetrical with the structure of the first drive buffer circuit 112, so that the signal transmission paths of the plurality of clock signals passing through the first drive buffer circuit 112 have the same length as signal transmission paths of a plurality of clock signals passing through the second drive buffer circuit 212, and the plurality of clock signals transmitted to the first clock mesh 120 have the same phase as the plurality of clock signals transmitted to the second clock mesh 220. This can resolve a problem of a large clock delay due to clock asynchronization between the dies. In addition, the clock signals of the first die 100 and the second die 200 are synchronized, and the clock signals of the first clock mesh 120 and the second clock mesh 220 are synchronized. This can reduce interconnection power consumption without crossing the clock domains.

In a possible implementation, the first drive buffer circuit 112 includes at least two layers of cascaded drive buffers (drive buffers), and the first drive buffer circuit 112 includes one input end and a plurality of output ends.

The drive buffer may be configured to relay and shape the clock signal, to drive a poststage circuit. FIG. 3 is a diagram 2 of a structure of a chiplet according to an embodiment of this application. A drive buffer circuit shown in FIG. 3 is used as an example to describe a cascaded structure of the first drive buffer circuit 112. The first drive buffer circuit 112 may include three layers of drive buffers. A drive buffer at a first layer may include one drive buffer, the drive buffer at the first layer may be coupled to two drive buffers at a second layer, and each drive buffer at the second layer may be coupled to two drive buffers at a third layer. Optionally, a drive buffer at an upper layer (for example, the first layer) may be coupled to a plurality of drive buffers at a lower layer (for example, the second layer), to implement cascading between the three layers of drive buffers. One input end of the first drive buffer circuit 112 is an input end of one drive buffer at an uppermost layer, and a plurality of output ends of the first drive buffer circuit 112 are output ends of a plurality of drive buffers at a lowermost layer respectively.

According to the chiplet provided in this embodiment of this application, signal attenuation occurs in the clock signal in the signal transmission path. In this embodiment of this application, the drive buffer is used to relay and shape the clock signal, to avoid clock waveform attenuation, and further maintain integrity of a clock signal waveform and normal propagation of the clock signal. In addition, the first drive buffer circuit 112 includes structures of the at least two layers of cascaded drive buffers, and the first drive buffer circuit 112 includes one input end and a plurality of output ends, so that when a small quantity of drive buffers are used, the first clock signal can be maintained, and one first clock signal can be converted into a plurality of second clock signals for output.

In addition, the clock mesh is of a topology structure of the clock circuit inside the chiplet. Each sequential logic circuit in the chiplet needs to be driven by the clock signal to implement data sending and sampling. The clock mesh may be configured to enable the clock signal to be transferred to each sequential logic circuit. In actual physical implementation, the clock mesh may use metal connection lines at different layers. Specifically, the clock mesh may be of a structure of a two-dimensional mesh in FIG. 3.

In a possible implementation, the first clock mesh 120 and the second clock mesh 220 each include routing in a first direction and routing in a second direction, where the first direction and the second direction are perpendicular to each other. The routing of the first clock mesh 120 in the first direction is aligned with the routing of the second clock mesh 220 in the first direction; or the routing of the first clock mesh 120 in the second direction is aligned with the routing of the second clock mesh 220 in the second direction.

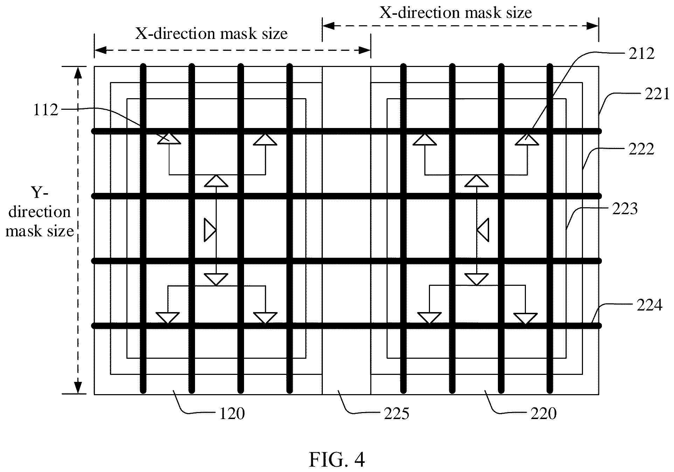

FIG. 4 is a diagram 1 of a clock mesh according to an embodiment of this application. In FIG. 4, a die edge 222 is disposed on an outer side of a chip edge (chip edge) 223, and a reticle edge (reticle edge) 221 is disposed on an outer side of the die edge 222. The chip edge 223 may be a layout boundary line, and the reticle edge 221 may be a boundary line of a single photolithography mask. The first direction may be a horizontal direction (an X direction), and the second direction may be a vertical direction (a Y direction). The first clock mesh 120 and the second clock mesh 220 may each include routing 224 in the X direction and routing 224 in the Y direction. The routing 224 of the first clock mesh 120 in the X direction and the routing 224 of the first clock mesh 120 in the Y direction are routing 224 at different layers. The routing 224 of the first clock mesh 120 in the X direction is aligned with the routing 224 of the second clock mesh 220 in the X direction, or the routing 224 of the first clock mesh 120 in the Y direction is aligned with the routing 224 of the second clock mesh 220 in the Y direction, so that the first clock mesh 120 and the second clock mesh 220 can be spliced at an overlapping region 225. Specifically, during processing and manufacturing, masks may be controlled to overlap at the overlapping region 225, and overlapping exposure is performed on the overlapping region 225. After the photoresist is developed to form a design pattern, etching is performed, and metal is deposited to form cross-mask-region splicing.

A size of each of the first mesh and the second mesh may be a size of the single photolithography mask. FIG. 4 shows X-direction mask sizes and Y-direction mask sizes of the first mesh and the second mesh. In this embodiment of this application, a symmetrical design is performed on routing 224 of the first clock mesh 120 and the second clock mesh 220, and is combined with processing and splicing of the photolithography mask, so that a clock mesh with a size greater than that of the single photolithography mask can be implemented, a plurality of dies on one wafer can be spliced into a large die with a physical size greater than that of the mask, allowing for a system on wafer (system on wafer, SOW) design or a wafer scale engine (wafer scale engine, WSE) design. In addition, the inside of the chiplet may be logically divided into a plurality of clock domains, clock frequencies of the clock domains are different, and each clock domain includes an independent clock mesh. In other words, each clock domain corresponds to one synchronization time, components in the domain are all synchronized with the time, and synchronization times corresponding to different clock domains are independent of each other. In this embodiment of this application, a plurality of clock meshes are spliced into a same clock mesh, so that a plurality of clock domains of a plurality of dies are unified into a same clock domain, to implement global clock synchronization. This resolves problems of a large clock delay and high power consumption due to clock asynchronization between cross-clock dies.

In a possible implementation, the first clock mesh 120 has a symmetrical structure, and the structure of the first clock mesh 120 is symmetrical with a structure of the second clock mesh 220. In this way, the first clock mesh 120 can output a plurality of third clock signals with a same phase based on the plurality of received second clock signals, to implement global clock synchronization. This can resolve a problem of a large clock delay due to clock asynchronization between dies and can reduce interconnection power consumption, without crossing clock domains.

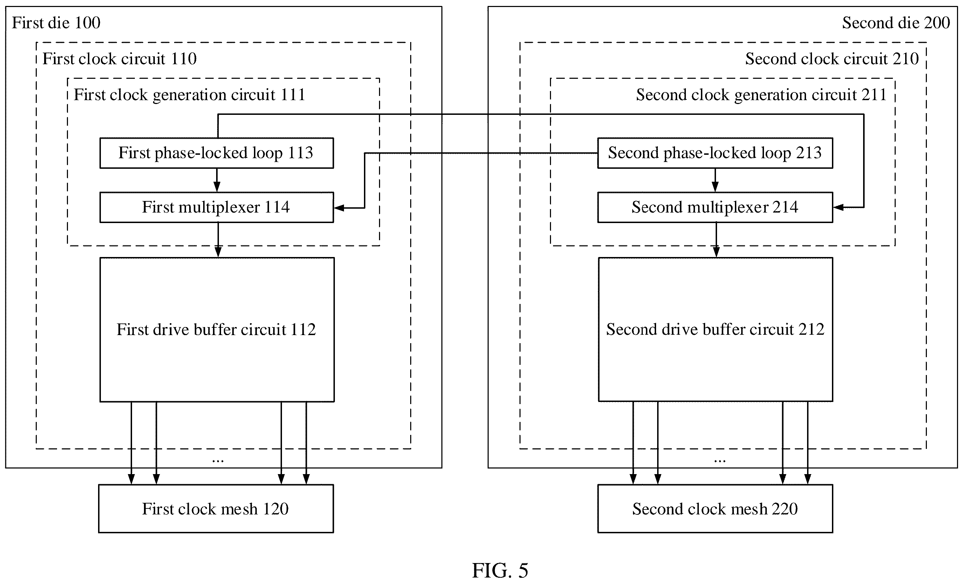

FIG. 5 is a diagram 3 of a structure of a chiplet according to an embodiment of this application. In a possible implementation, as shown in FIG. 5, the first clock generation circuit 111 includes a first phase-locked loop 113 and a first multiplexer 114, the second clock circuit 210 further includes a second clock generation circuit 211, and the second clock generation circuit 211 includes a second phase-locked loop 213 and a second multiplexer 214. A first input end and a second input end of the first multiplexer 114 are coupled to a first output end of the first phase-locked loop 113 and a second output end of the second phase-locked loop 213 respectively, and an output end of the first multiplexer 114 is coupled to an input end of the first drive buffer circuit 112. A first input end and a second input end of the second multiplexer 214 are coupled to a first output end of the second phase-locked loop 213 and a second output end of the first phase-locked loop 113 respectively, and an output end of the second multiplexer 214 is coupled to an input end of the second drive buffer circuit 212.

The first multiplexer 114 and the second multiplexer 214 may be data multiplexers. A data multiplexer (multiplexer, MUX) may select a specified input signal from a group of input signals based on given input address code to send the selected specified input signal to a combinational logic circuit at an output end. The data multiplexer may also be referred to as a multiplexer or a multichannel modulator. The first multiplexer 114 and the second multiplexer 214 are disposed, so that one phase-locked loop may be selected from the first phase-locked loop 113 and the second phase-locked loop 213 as a clock source.

The output end of the first multiplexer 114 is the first output end of the first clock generation circuit 111. The second output end of the first phase-locked loop 113 is the second output end of the first clock generation circuit 111, and the second output end of the first clock generation circuit 111 may be coupled to the input end of the second drive buffer circuit 212 via the second multiplexer 214.

The following briefly describes a circuit principle of this embodiment. The first phase-locked loop 113 is configured to output a first clock signal. The second phase-locked loop 213 is configured to output a first clock signal. The first multiplexer 114 is configured to receive the first clock signal output by the first phase-locked loop 113 and/or the first clock signal output by the second phase-locked loop 213, and output a first clock signal. The second multiplexer 214 is configured to receive the first clock signal output by the first phase-locked loop 113 and/or the first clock signal output by the second phase-locked loop 213, and output the first clock signal.

For example, the first die 100 is a master die, and the first phase-locked loop 113 is a clock source. The first phase-locked loop 113 outputs the first clock signal, and the second phase-locked loop 213 does not operate. The first multiplexer 114 receives the first clock signal of the first phase-locked loop 113 via the first input end, and outputs the first clock signal of the first phase-locked loop 113. The second multiplexer 214 receives the first clock signal of the first phase-locked loop 113 via the second input end, and outputs the first clock signal of the first phase-locked loop 113.

For example, the first die 100 is a master die, and the first phase-locked loop 113 is a clock source. The first phase-locked loop 113 outputs the first clock signal, and the second phase-locked loop 213 also outputs the first clock signal. The first multiplexer 114 receives the first clock signal of the first phase-locked loop 113 via the first input end, receives the first clock signal of the second phase-locked loop 213 via the second input end, and selects to output the first clock signal of the first phase-locked loop 113. The second multiplexer 214 receives the first clock signal of the second phase-locked loop 213 via the first input end, receives the first clock signal of the first phase-locked loop 113 via the second input end, and selects to output the first clock signal of the first phase-locked loop 113.

For example, a length of a signal transmission path between the first output end of the first phase-locked loop 113 and the first input end of the first multiplexer 114 is equal to a length of a signal transmission path between the second output end of the first phase-locked loop 113 and the second input end of the second multiplexer 214. A length of a signal transmission path between the first output end of the second phase-locked loop 213 and the first input end of the second multiplexer 214 is equal to a length of a signal transmission path between the second output end of the second phase-locked loop 213 and the second input end of the first multiplexer 114. This can avoid a case in which when the first clock signal output by the first phase-locked loop 113 separately reaches the first multiplexer 114 and the second multiplexer 214, the first clock signal received by the first multiplexer 114 is not the same, in phase, as the first clock signal received by the second multiplexer 214.

According to the chiplet provided in this embodiment of this application, the second phase-locked loop 213, the first multiplexer 114, and the second multiplexer 214 are disposed, so that different dies can be used as master dies to output clock source signals. This can be used in more scenarios, to enrich functions of the chiplet. In addition, the length of the signal transmission path between the first output end of the first phase-locked loop 113 and the first input end of the first multiplexer 114 is equal to the length of the signal transmission path between the second output end of the first phase-locked loop 113 and the second input end of the second multiplexer 214, so that clock signals of the first die 100 and the second die 200 are synchronized, and clock signals of the first clock mesh 120 and the second clock mesh 220 are synchronized. This can resolve a problem of a large clock delay due to clock asynchronization between dies and can further reduce interconnection power consumption, without crossing clock domains.

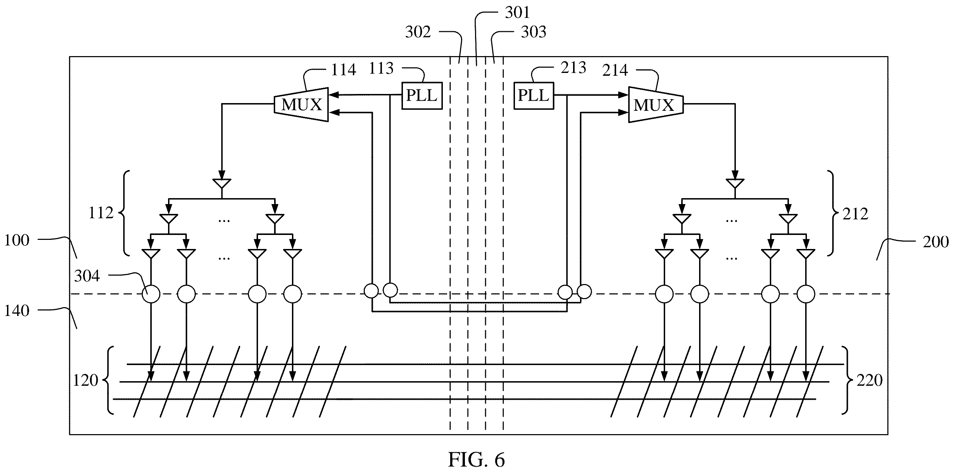

FIG. 6 is a diagram 4 of a structure of a chiplet according to an embodiment of this application. In a possible implementation, as shown in FIG. 6, the chiplet further includes a silicon interposer 140. The first clock mesh 120 and the second clock mesh 220 are disposed in the silicon interposer 140, and are connected to each other via the silicon interposer 140. The silicon interposer 140 is further configured to connect the first clock circuit 110 to the second clock circuit 210.

For example, first routing is disposed in the silicon interposer 140. The first routing is configured to connect the first clock mesh 120 to the second clock mesh 220, and is further configured to connect the first clock circuit 110 to the second clock circuit 210. Specifically, when the chiplet includes only the first phase-locked loop 113 and does not include the first multiplexer 114 and the second clock generation circuit 211, the first routing is configured to connect the first clock mesh 120 to the second clock mesh 220, and is further configured to connect the first phase-locked loop 113 to the second drive buffer circuit 212. When the chiplet further includes the first multiplexer 114 and the second clock generation circuit 211, the first routing is configured to connect the first clock mesh 120 to the second clock mesh 220, is further configured to connect the first phase-locked loop 113 to the second multiplexer 214, and is further configured to connect the second phase-locked loop 213 to the first multiplexer 114. Partial routing that is of the first routing and that is used to connect the first clock mesh 120 to the second clock mesh 220 may also belong to the first clock mesh 120 and the second clock mesh 220.

According to the chiplet provided in this embodiment of this application, the first clock mesh 120 and the second clock mesh 220 are connected to each other via the silicon interposer 140, and the first clock circuit 110 and the second clock circuit 210 are connected to each other via the silicon interposer 140, so that a plurality of clock domains of a plurality of dies are unified into a same clock domain, to implement global clock synchronization. This resolves problems of a large clock delay and high power consumption due to clock asynchronization between cross-clock dies.

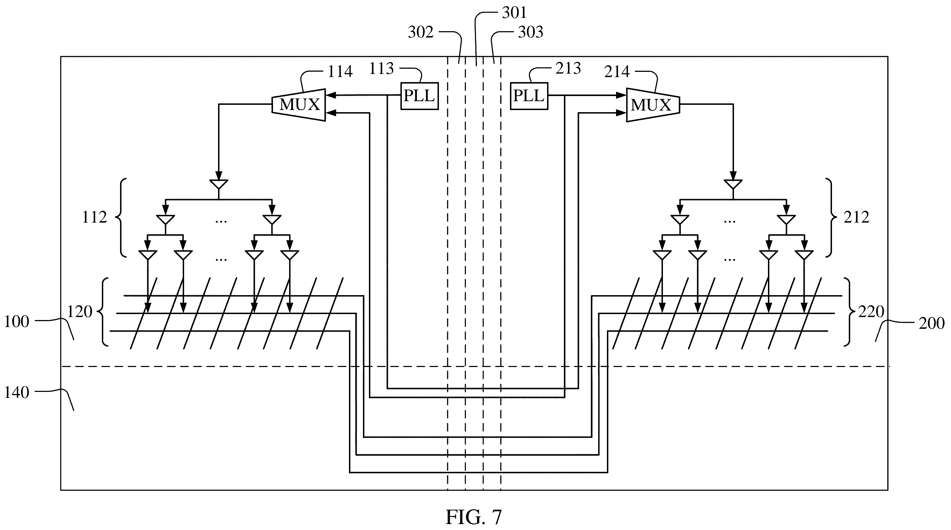

FIG. 7 is a diagram 5 of a structure of a chiplet according to an embodiment of this application. In a possible implementation, as shown in FIG. 7, the chiplet further includes the silicon interposer 140. The first clock mesh 120 is disposed in the first die 100. The second clock mesh 220 is disposed in the second die 200, and the first clock mesh 120 and the second clock mesh 220 are connected to each other via the silicon interposer 140. The silicon interposer 140 is further configured to connect the first clock circuit 110 to the second clock circuit 210.

For example, second routing is disposed in the silicon interposer 140. The second routing is configured to connect the first clock mesh 120 to the second clock mesh 220, and is further configured to connect the first clock circuit 110 to the second clock circuit 210. Specifically, when the chiplet includes only the first phase-locked loop 113 and does not include the first multiplexer 114 and the second clock generation circuit 211, the second routing is configured to connect the first clock mesh 120 to the second clock mesh 220, and is further configured to connect the first phase-locked loop 113 to the second drive buffer circuit 212. When the chiplet further includes the first multiplexer 114 and the second clock generation circuit 211, the second routing is configured to connect the first clock mesh 120 to the second clock mesh 220, is further configured to connect the first phase-locked loop 113 to the second multiplexer 214, and is further configured to connect the second phase-locked loop 213 to the first multiplexer 114.

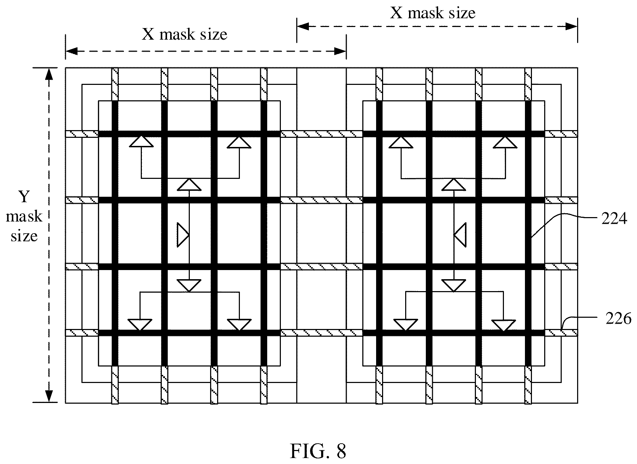

Optionally, FIG. 8 is a diagram 2 of a clock mesh according to an embodiment of this application. As shown in FIG. 8, the second routing includes mesh routing 226, and the mesh routing 226 is partial routing used to connect the first clock mesh 120 to the second clock mesh 220. The mesh routing 226 may also belong to the first clock mesh 120 and the second clock mesh 220.

According to the chiplet provided in this embodiment of this application, the first clock mesh 120 and the second clock mesh 220 are connected to each other via the silicon interposer 140, and the first clock circuit 110 and the second clock circuit 210 are connected to each other via the silicon interposer 140, so that a plurality of clock domains of a plurality of dies are unified into a same clock domain, to implement global clock synchronization. This resolves problems of a large clock delay and high power consumption due to clock asynchronization between cross-clock dies.

In a possible implementation, the first die 100 and the second die 200 are located on a same wafer. Specifically, as shown in FIG. 7, the first die 100 and the second die 200 may be spliced together. According to the chiplet provided in this embodiment of this application, the first die 100 and the second die 200 are placed on the same wafer. This resolves problems of a large clock delay and high power consumption due to clock asynchronization between cross-clock dies.

In a possible implementation, the chiplet further includes a first sealing ring 302, a second sealing ring 303, and a dicing groove 301, the first sealing ring 302 is disposed between the first die 100 and the dicing groove 301, and the second sealing ring 303 is disposed between the second die 200 and the dicing groove 301.

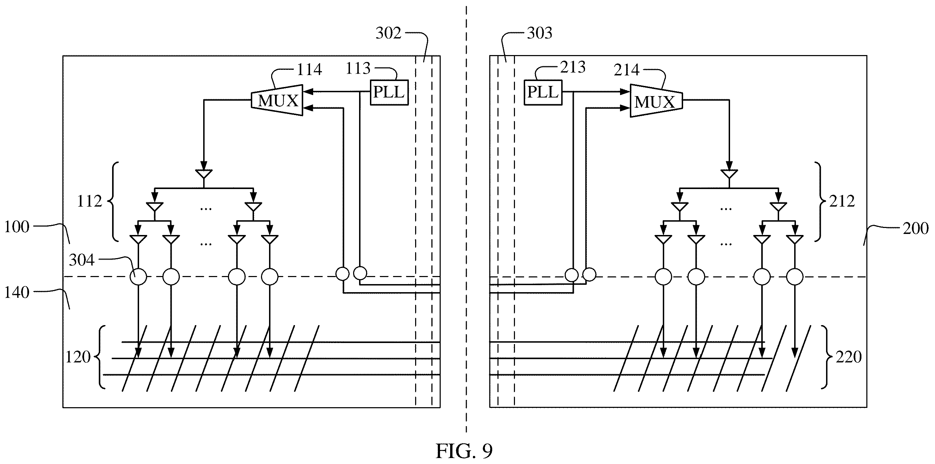

As shown in FIG. 7, the dicing groove 301 may be disposed between the first die 100 and the second die 200. The first die 100 and the second die 200 may be cut by dicing the dicing groove 301. The first sealing ring 302 and the second sealing ring 303 may alternatively be disposed on two sides of the overlapping region 225 in the silicon interposer 140. The sealing ring is used to prevent the chiplet from being mechanically damaged during cutting. FIG. 9 is a diagram of a position at which a chiplet is cut according to an embodiment of this application. As shown in FIG. 9, the dicing groove 301 and the overlapping region 225 between the first sealing ring 302 and the second sealing ring 303 are cut, to cut the first die 100 and the second die 200 in the chiplet and cut the silicon interposer 140 into a first silicon interposer and a second silicon interposer, so as to cut the chiplet into a first integrated apparatus and a second integrated apparatus. The first integrated apparatus may include the first die 100 and the first silicon interposer bonded to the first die 100. The second integrated apparatus may include the second die 200 and the second silicon interposer bonded to the second die 200. The first silicon interposer may include the first clock mesh 120, and the second silicon interposer may include the second clock mesh 220.

According to the chiplet provided in this embodiment of this application, the dicing groove 301, the first sealing ring 302, and the second sealing ring 303 are disposed, so that the first die 100 and the second die 200 can be flexibly cut or spliced, and the first clock mesh 120 and the second clock mesh 220 can be flexibly cut or spliced. In this way, one large clock mesh can be cut into a plurality of separate small clock meshes, to support a flexible architecture of the chiplet, and improve interconnection competitiveness of the chiplet.

In a possible implementation, as shown in FIG. 7, the first die 100 is grown on the silicon interposer 140, or as shown in FIG. 6, the first die 100 is bonded to the silicon interposer 140 via a micro bump 304; and/or the second die 200 is grown on the silicon interposer 140, or the second die 200 is bonded to the silicon interposer 140 via a micro bump 304.

According to the chiplet provided in this embodiment of this application, the die is grown on the silicon interposer 140, or the die is bonded to the silicon interposer 140 via the micro bump 304, to form a complete clock system, so that a plurality of clock domains of a plurality of dies are unified into a same clock domain, to implement global clock synchronization. This resolves problems of a large clock delay and high power consumption due to clock asynchronization between cross-clock dies.

In a possible implementation, the first die 100 and the second die 200 are of a heterostructure. That the first die 100 and the second die 200 are of the heterostructure may mean that the first die 100 is different from the second die 200 in material, process, or the like. According to the chiplet provided in this embodiment of this application, a chiplet including a heterostructure can be used, has diverse application scenarios, and can resolve the problems of the large clock delay and high power consumption due to the clock asynchronization between the cross-clock dies.

In a possible implementation, either the first clock circuit 110 or the second clock circuit 210 further includes a phase adjustment circuit. A first input end of the phase adjustment circuit is coupled to a second output end of the drive buffer circuit that is located on a same die as the clock circuit. A second input end of the phase adjustment circuit is coupled to an output end of the first clock generation circuit 111. An output end of the phase adjustment circuit is coupled to an input end of the drive buffer circuit that is located on the same die as the clock circuit. A third input end of the phase adjustment circuit of the first clock circuit 110 is coupled to a second output end of the drive buffer circuit of the second clock circuit 210, and/or a third input end of the phase adjustment circuit of the second clock circuit 210 is coupled to a second output end of the drive buffer circuit of the first clock circuit 110.

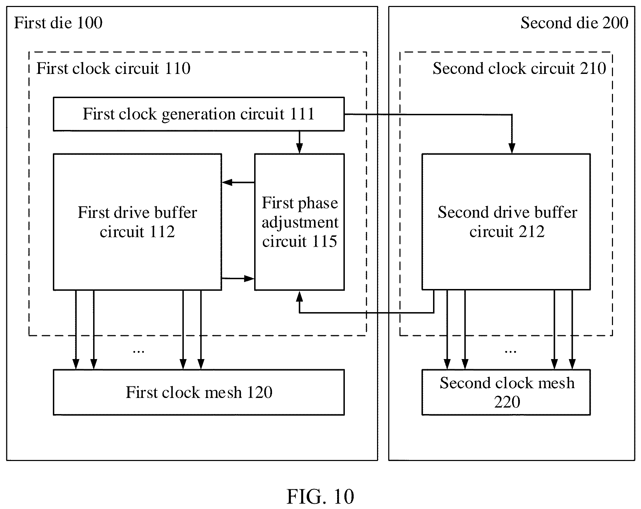

FIG. 10 is a diagram 6 of a structure of a chiplet according to an embodiment of this application. For example, the first clock circuit 110 further includes a first phase adjustment circuit 115. A first input end of the first phase adjustment circuit 115 is coupled to a second output end of the first drive buffer circuit 112. A second input end of the first phase adjustment circuit 115 is coupled to a second output end of the second drive buffer circuit 212. A third input end of the first phase adjustment circuit 115 is coupled to a first output end of the first clock generation circuit 111. An output end of the first phase adjustment circuit 115 is coupled to an input end of the first drive buffer circuit 112.

The structure in FIG. 10 is used as an example to briefly describe a circuit principle in this embodiment. The first phase adjustment circuit 115 is configured to receive a second clock signal output by the first drive buffer circuit 112, a second clock signal output by the second drive buffer circuit 212, and a first clock signal output by the first clock generation circuit 111, to output an adjusted first clock signal. The first drive buffer circuit 112 constantly adjusts a level based on the received adjusted first clock signal, until a phase of the output second clock signal is the same as a phase of the second clock signal output by the second drive buffer circuit 212.

For example, the first die 100 is a master die, and the first clock generation circuit 111 outputs the first clock signal. Before phase adjustment, the first drive buffer circuit 112 receives the first clock signal via the first phase adjustment circuit 115, and outputs the second clock signal based on the first clock signal. The second drive buffer circuit 212 receives the first clock signal, and outputs the second clock signal based on the first clock signal. The first phase adjustment circuit 115 receives the second clock signal output by the first drive buffer circuit 112 and the second clock signal output by the second drive buffer circuit 212, and detects whether the second clock signal output by the first drive buffer circuit 112 and the second clock signal output by the second drive buffer circuit 212 are the same in phase. When the second clock signal output by the first drive buffer circuit 112 and the second clock signal output by the second drive buffer circuit 212 are not the same in phase, the first phase adjustment circuit 115 outputs the adjusted first clock signal, and the first drive buffer circuit 112 constantly adjusts the level based on the received adjusted first clock signal, until a second clock signal that is the same as the second clock signal output by the second drive buffer circuit 212 in phase is output. In this way, phase adjustment of the clock signal of the first die 100 is completed.

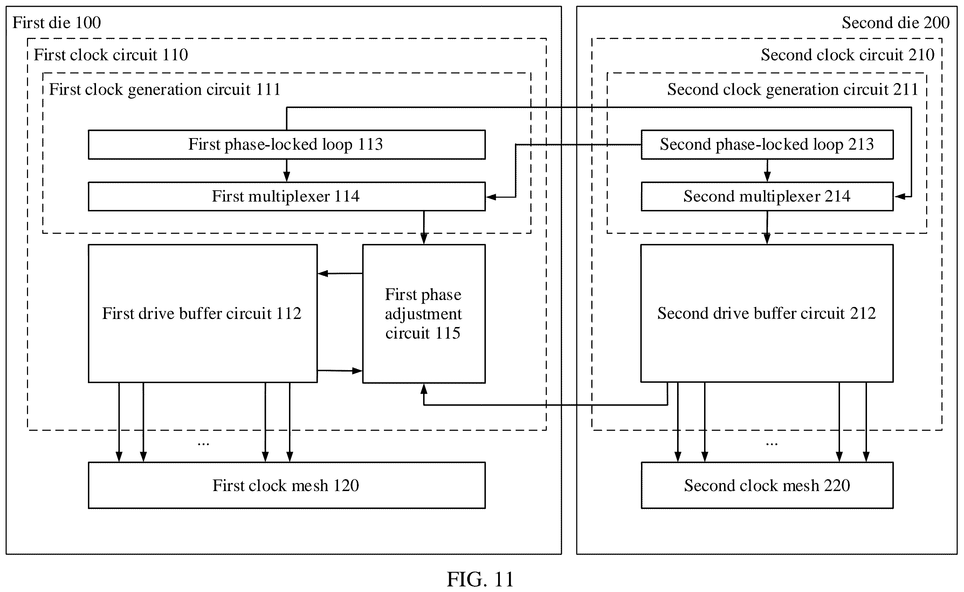

FIG. 11 is a diagram 7 of a structure of a chiplet according to an embodiment of this application. For example, the first clock generation circuit 111 includes the first phase-locked loop 113 and the first multiplexer 114, the second clock circuit 210 further includes the second clock generation circuit 211, and the second clock generation circuit 211 includes the second phase-locked loop 213 and the second multiplexer 214. For a relationship and principle of connection between the first phase-locked loop 113 and the first multiplexer 114, and a relationship and principle of connection between the second phase-locked loop 213 and the second multiplexer 214, refer to the connection relationship and principle in the foregoing embodiment. Details are not described herein again.

For example, the first die 100 is a master die, and the first multiplexer 114 and the first multiplexer 114 receive a first clock signal from the first phase-locked loop 113 and a first clock signal from the second phase-locked loop 213, and select to output the first clock signal of the first phase-locked loop 113. The first phase adjustment circuit 115 receives and detects whether a second clock signal output by the first drive buffer circuit 112 and a second clock signal output by the second drive buffer circuit 212 are the same in phase. When the second clock signal output by the first drive buffer circuit 112 and the second clock signal output by the second drive buffer circuit 212 are not the same in phase, the first phase adjustment circuit 115 outputs an adjusted first clock signal, and the first drive buffer circuit 112 constantly adjusts a level based on the received adjusted first clock signal, until a second clock signal that is the same as the second clock signal output by the second drive buffer circuit 212 in phase is output. In this way, phase adjustment of the clock signal of the first die 100 is completed.

For example, the first clock generation circuit 111 is further configured to receive a reference clock signal. In this example, the first phase-locked loop 113 may be used as a clock source of the first die 100, and the first multiplexer 114 selects to output the first clock signal of the first phase-locked loop 113. The second phase-locked loop 213 is used as a clock source of the second die 200, and the second multiplexer 214 selects to output the first clock signal of the second phase-locked loop 213. To avoid large clock jitters of phases of the first clock signal output by the first phase-locked loop 113 and the first clock signal output by the second phase-locked loop 213, a reference clock is coupled between the first phase-locked loop 113 and the second phase-locked loop 213, and the first phase-locked loop 113 receives the reference clock signal, to adjust the phase of the first clock signal to be the same as a phase of the first clock signal of the second phase-locked loop 213. Then, the first phase adjustment circuit 115 receives and detects whether the second clock signal output by the first drive buffer circuit 112 and the second clock signal output by the second drive buffer circuit 212 are the same in phase. When the second clock signal output by the first drive buffer circuit 112 and the second clock signal output by the second drive buffer circuit 212 are not the same in phase, the first phase adjustment circuit 115 outputs an adjusted first clock signal, and the first drive buffer circuit 112 constantly adjusts a level based on the received adjusted first clock signal, until a second clock signal that is the same as the second clock signal output by the second drive buffer circuit 212 in phase is output. In this way, phase adjustment of the clock signal of the first die 100 is completed.

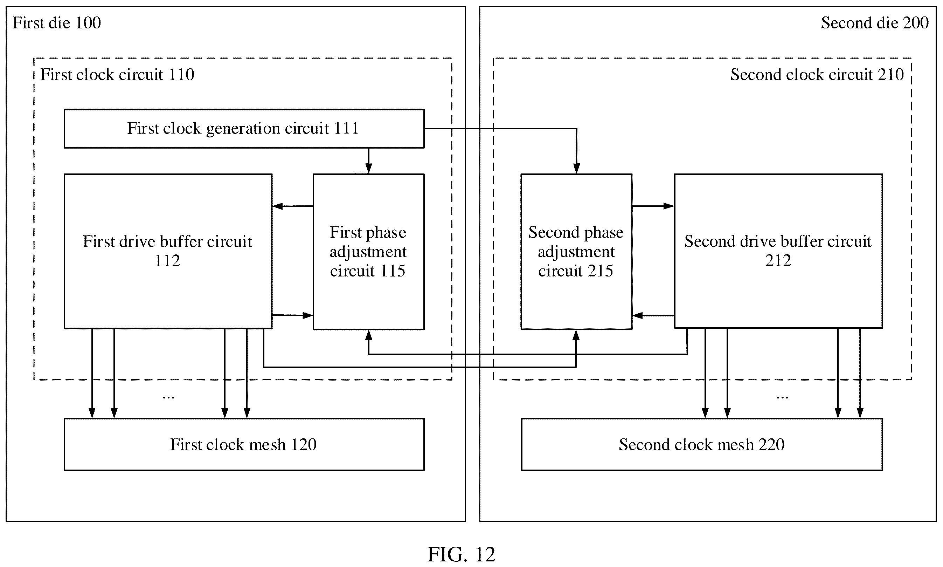

FIG. 12 is a diagram 8 of a structure of a chiplet according to an embodiment of this application. For example, the second clock circuit 210 further includes a second phase adjustment circuit 215. A first input end of the second phase adjustment circuit 215 is coupled to a second output end of the second drive buffer circuit 212, a second input end of the second phase adjustment circuit 215 is coupled to a second output end of the first drive buffer circuit 112, a third input end of the second phase adjustment circuit 215 is coupled to a second output end of the first clock generation circuit 111, and an output end of the second phase adjustment circuit 215 is coupled to an input end of the second drive buffer circuit 212.

The structure in FIG. 12 is used as an example to briefly describe a circuit principle in this embodiment. The second phase adjustment circuit 215 is configured to receive a second clock signal output by the second drive buffer circuit 212, a second clock signal output by the first drive buffer circuit 112, and a first clock signal output by the first clock generation circuit 111, to output an adjusted first clock signal. The second drive buffer circuit 212 constantly adjusts a level based on the received adjusted first clock signal, until a phase of the output second clock signal is the same as a phase of the second clock signal output by the first drive buffer circuit 112.

For example, the first die 100 is a master die, and the first clock generation circuit 111 outputs the first clock signal. Before phase adjustment, the first drive buffer circuit 112 receives the first clock signal via the first phase adjustment circuit 115, and outputs the second clock signal based on the first clock signal. The second drive buffer circuit 212 receives the first clock signal via the second phase adjustment circuit 215, and outputs the second clock signal based on the first clock signal. In this example, the second phase adjustment circuit 215 operates, and the first phase adjustment circuit 115 does not operate. The second phase adjustment circuit 215 receives the second clock signal output by the first drive buffer circuit 112 and the second clock signal output by the second drive buffer circuit 212, and detects whether the second clock signal output by the first drive buffer circuit 112 and the second clock signal output by the second drive buffer circuit 212 are the same in phase. When the second clock signal output by the first drive buffer circuit 112 and the second clock signal output by the second drive buffer circuit 212 are not the same in phase, the second phase adjustment circuit 215 outputs the adjusted first clock signal, and the second drive buffer circuit 212 constantly adjusts the level based on the received adjusted first clock signal, until a second clock signal that is the same as the second clock signal output by the first drive buffer circuit 112 in phase is output. In this way, phase adjustment of the clock signal of the second die 200 is completed.

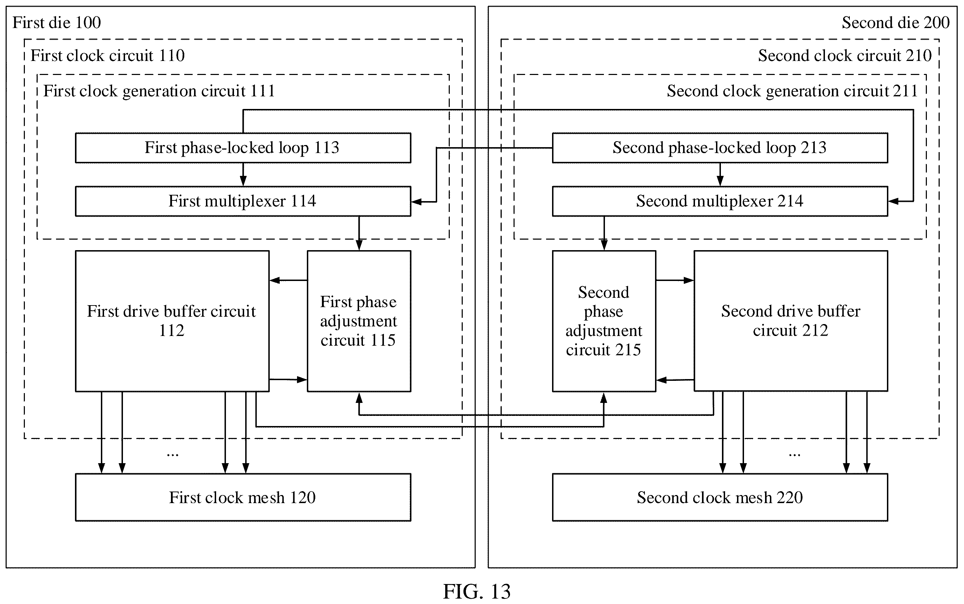

FIG. 13 is a diagram 9 of a structure of a chiplet according to an embodiment of this application. For example, the first clock generation circuit 111 includes the first phase-locked loop 113 and the first multiplexer 114, the second clock circuit 210 further includes the second clock generation circuit 211, and the second clock generation circuit 211 includes the second phase-locked loop 213 and the second multiplexer 214. For a relationship and principle of connection between the first phase-locked loop 113 and the first multiplexer 114, and a relationship and principle of connection between the second phase-locked loop 213 and the second multiplexer 214, refer to the connection relationship and principle in the foregoing embodiment. Details are not described herein again.

For example, in this embodiment, the first phase-locked loop 113 may be used as a clock source of the first die 100 and the second die 200, or the second phase-locked loop 213 may be used as a clock source of the first die 100 and the second die 200. Alternatively, the first phase-locked loop 113 may be used as a clock source of the first die 100, the second phase-locked loop 213 may be used as a clock source of the second die 200, and the first phase-locked loop 113 and the second phase-locked loop 213 receive a reference clock signal. Alternatively, the second phase-locked loop 213 may be used as a clock source of the first die 100, the first phase-locked loop 113 may be used as a clock source of the second die 200, and the first phase-locked loop 113 and the second phase-locked loop 213 receive a reference clock signal. In this embodiment, the first phase adjustment circuit 115 may be controlled to operate, and the second phase adjustment circuit 215 may be controlled not to operate. Alternatively, the second phase adjustment circuit 215 may be controlled to operate, and the first phase adjustment circuit 115 may be controlled not to operate.

For example, if the chiplet includes the first die 100 and the second die 200, a phase adjustment circuit in the first die 100 or the second die 200 may be controlled to operate, to adjust a phase of a clock signal of a die in which the phase adjustment circuit is located. If the chiplet includes the first die 100, the second die 200, and a third die, phase adjustment circuits in the second die 200 and the third die may be controlled to operate, and a phase adjustment circuit in the first die 100 may be controlled not to operate, to adjust clock signals of the second die 200 and the third die based on a phase of a clock signal of the first die 100. This embodiment may also be applied to more dies. This is not limited in embodiments of this application.

When the first clock circuit 110 and the second clock circuit 210 are of a heterostructure, and when a clock signal is transmitted in the first clock circuit 110 and a clock signal is transmitted in the second clock circuit 210, phases of the two clock signals may change. According to the chiplet provided in this embodiment of this application, the phase adjustment circuit is disposed, to adjust a second clock signal of the first clock circuit 110 and/or a second clock signal of the second clock circuit 210 in time, so that clock signals received by the first clock mesh 120 and the second clock mesh 220 are the same in phase. In this way, the clock signals of the first die 100 and the second die 200 are synchronized, and the clock signals of the first clock mesh 120 and the second clock mesh 220 are synchronized. This can resolve a problem of a large clock delay due to clock asynchronization between dies and can further reduce interconnection power consumption, without crossing clock domains.

In a possible implementation, the phase adjustment circuit includes a phase detector (phase detector, PD), a phase alignment (phase alignment, PA) circuit, and a phase interpolator (phase interpolator, PI).

A first input end of the phase detector is coupled to a second output end of the drive buffer circuit that is located on the same die as the clock circuit. An output end of the phase detector is coupled to an input end of the phase alignment circuit. A first input end of the phase interpolator is coupled to an output end of the phase alignment circuit. A second input end of the phase interpolator is coupled to an output end of the first clock generation circuit 111. An output end of the phase interpolator is coupled to an input end of the drive buffer circuit that is located on the same die as the clock circuit. A second input end of a phase detector of the first clock circuit 110 is coupled to a second output end of the drive buffer circuit of the second clock circuit 210, and/or a second input end of a phase detector of the second clock circuit 210 is coupled to a second output end of the drive buffer circuit of the first clock circuit 110.

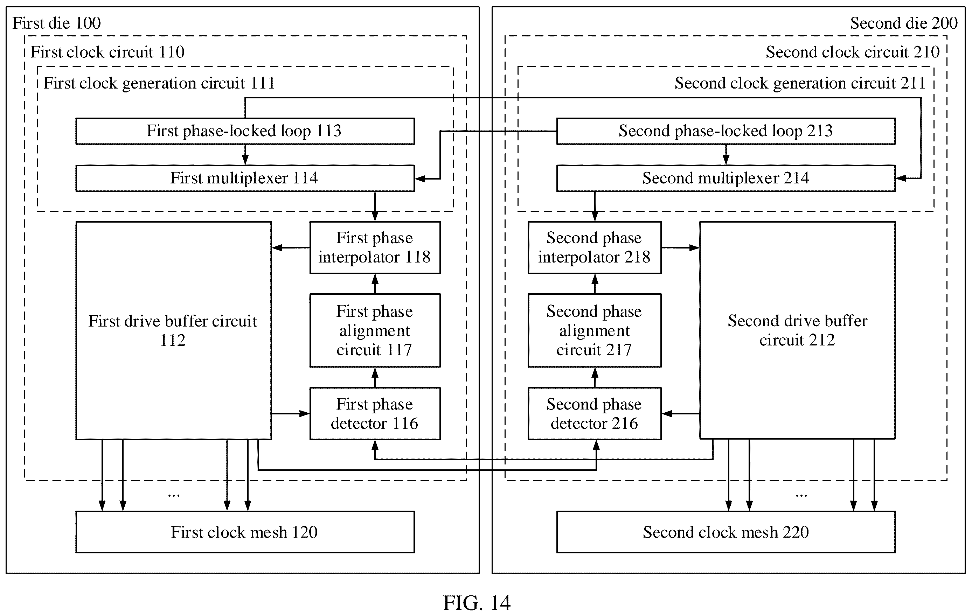

FIG. 14 is a diagram 10 of a structure of a chiplet according to an embodiment of this application. For example, the first phase adjustment circuit 115 includes a first phase detector 116, a first phase alignment circuit 117, and a first phase interpolator 118. A first input end of the first phase detector 116 is coupled to a second output end of the first drive buffer circuit 112, a second input end of the first phase detector 116 is coupled to a second output end of the second drive buffer circuit 212, and an output end of the first phase detector 116 is coupled to an input end of the first phase alignment circuit 117. A first input end of the first phase interpolator 118 is coupled to an output end of the first phase alignment circuit 117, a second input end of the first phase interpolator 118 is coupled to a first output end of the first clock generation circuit 111, and an output end of the first phase interpolator 118 is coupled to an input end of the first drive buffer circuit 112.

The structure in FIG. 14 is used as an example to briefly describe a circuit principle in this embodiment. The first phase detector 116 is configured to receive a second clock signal output by the first drive buffer circuit 112 and a second clock signal output by the second drive buffer circuit 212, to output first phase detection information, where the first phase detection information indicates whether the second clock signal output by the first drive buffer circuit 112 and the second clock signal output by the second drive buffer circuit 212 are the same in phase. The first phase alignment circuit 117 is configured to receive the first phase detection information, and output first phase adjustment information, where the first phase adjustment information indicates, when the second clock signal output by the first drive buffer circuit 112 and the second clock signal output by the second drive buffer circuit 212 are not the same in phase, a target adjustment value of a phase of a first clock signal output by the first clock generation circuit 111. The first phase interpolator 118 is configured to receive the first phase adjustment information and the first clock signal output by the first clock generation circuit 111, and output an adjusted first clock signal based on the target adjustment value.

For example, the second phase adjustment circuit 215 includes a second phase detector 216, a second phase alignment circuit 217, and a second phase interpolator 218. A first input end of the second phase detector 216 is coupled to the second output end of the second drive buffer circuit 212, a second input end of the second phase detector 216 is coupled to the second output end of the first drive buffer circuit 112, and an output end of the second phase detector 216 is coupled to an input end of the second phase alignment circuit 217. A first input end of the second phase interpolator 218 is coupled to an output end of the second phase alignment circuit 217, a second input end of the second phase interpolator 218 is coupled to a second output end of the first clock generation circuit 111, and an output end of the second phase interpolator 218 is coupled to an input end of the second drive buffer circuit 212.

The structure in FIG. 14 is used as an example to briefly describe a circuit principle in this embodiment. The second phase detector 216 is configured to receive the second clock signal output by the second drive buffer circuit 212 and the second clock signal output by the first drive buffer circuit 112, to output second phase detection information, where the second phase detection information indicates whether the second clock signal output by the second drive buffer circuit 212 and the second clock signal output by the first drive buffer circuit 112 are the same in phase. The second phase alignment circuit 217 is configured to receive the second phase detection information, and output second phase adjustment information, where the second phase adjustment information indicates, when the second clock signal output by the second drive buffer circuit 212 and the second clock signal output by the first drive buffer circuit 112 are not the same in phase, a target adjustment value of a phase of the first clock signal output by the first clock generation circuit 111. The second phase interpolator 218 is configured to receive the second phase adjustment information and the first clock signal output by the first clock generation circuit 111, and output an adjusted first clock signal based on the target adjustment value.

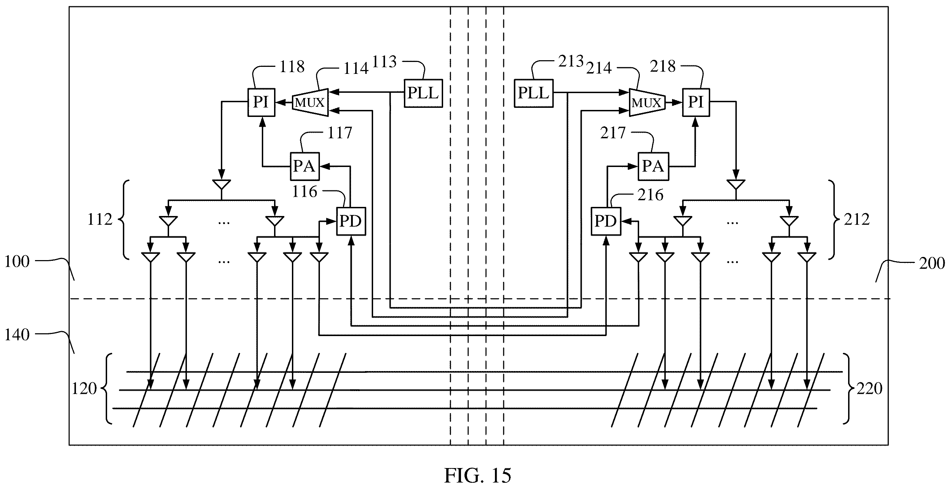

FIG. 15 is a diagram 11 of a structure of a chiplet according to an embodiment of this application. In a possible implementation, as shown in FIG. 15, the chiplet further includes the silicon interposer 140. The first clock mesh 120 and the second clock mesh 220 are disposed in the silicon interposer 140. The first clock mesh 120 and the second clock mesh 220 are connected to each other via the silicon interposer 140. The silicon interposer 140 is further configured to connect the first clock circuit 110 to the second clock circuit 210.

For example, first routing is disposed in the silicon interposer 140. The first routing is further configured to connect an input end of the first phase detector 116 to a second output end of a second drive circuit, and is further configured to connect an input end of the second phase detector 216 to a second output end of a first drive circuit.

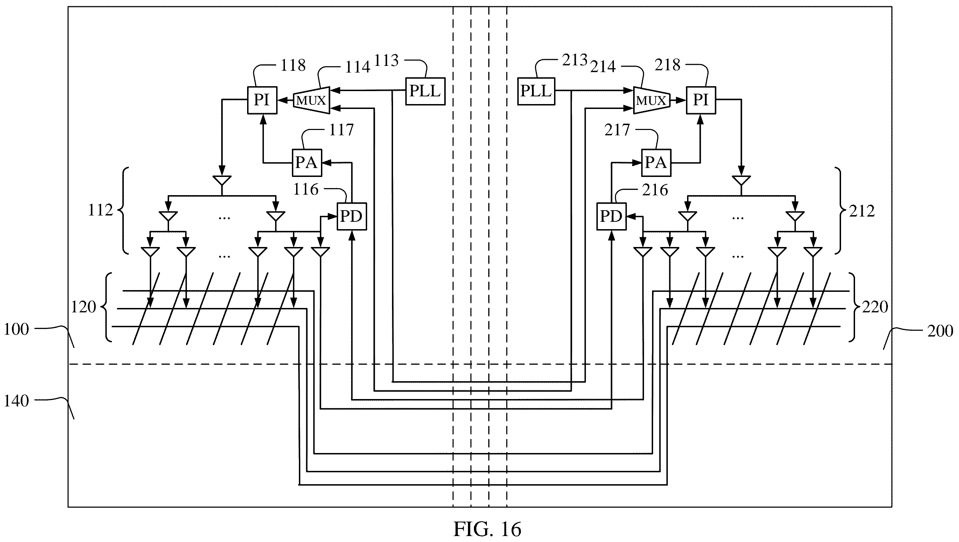

FIG. 16 is a diagram 12 of a structure of a chiplet according to an embodiment of this application. In a possible implementation, as shown in FIG. 16, the chiplet further includes the silicon interposer 140. The first clock mesh 120 is disposed in the first die 100, the second clock mesh 220 is disposed in the second die 200, and the first clock mesh 120 and the second clock mesh 220 are connected to each other via the silicon interposer 140. The silicon interposer 140 is further configured to connect the first clock circuit 110 to the second clock circuit 210.

For example, second routing is disposed in the silicon interposer 140. The second routing is further configured to connect an input end of the first phase detector 116 to a second output end of a second drive circuit, and is further configured to connect an input end of the second phase detector 216 to a second output end of a first drive circuit.

When the first clock circuit 110 and the second clock circuit 210 are of a heterostructure, and when a clock signal is transmitted in the first clock circuit 110 and a clock signal is transmitted in the second clock circuit 210, phases of the two clock signals may change. According to the chiplet provided in this embodiment of this application, a phase detector, a phase alignment circuit, and a phase interpolator are disposed, to adjust a second clock signal of the first clock circuit 110 and/or a second clock signal of the second clock circuit 210 in time, so that clock signals received by the first clock mesh 120 and the second clock mesh 220 are the same in phase. In this way, the clock signals of the first die 100 and the second die 200 are synchronized, and the clock signals of the first clock mesh 120 and the second clock mesh 220 are synchronized. This can resolve a problem of a large clock delay due to clock asynchronization between dies and can further reduce interconnection power consumption, without crossing clock domains.

According to another aspect of embodiments of this application, an electronic device is provided. The electronic device includes a printed circuit board (printed circuit board, PCB) and at least one chiplet. Structures of the chiplet may be shown in FIG. 2 to FIG. 16. The chiplet is disposed on one side of the PCB and is electrically connected to the PCB.

In conclusion, the foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A chiplet, comprising a first die, a second die, a first clock mesh, and a second clock mesh, wherein
the first die comprises a first clock circuit, and the first clock circuit comprises a first clock generation circuit and a first drive buffer circuit; and
the second die comprises a second clock circuit, and the second clock circuit comprises a second drive buffer circuit, wherein
an input end of the first drive buffer circuit is coupled to a first output end of the first clock generation circuit, and a first output end of the first drive buffer circuit is coupled to an input end of the first clock mesh; and
an input end of the second drive buffer circuit is coupled to a second output end of the first clock generation circuit, and a first output end of the second drive buffer circuit is coupled to an input end of the second clock mesh.

2. The chiplet according to claim 1, wherein the first clock generation circuit comprises a first phase-locked loop and a first multiplexer, and the second clock circuit further comprises a second clock generation circuit, wherein the second clock generation circuit comprises a second phase-locked loop and a second multiplexer;
a first input end and a second input end of the first multiplexer are coupled to a first output end of the first phase-locked loop and a second output end of the second phase-locked loop respectively, and an output end of the first multiplexer is coupled to the input end of the first drive buffer circuit; and
a first input end and a second input end of the second multiplexer are coupled to a first output end of the second phase-locked loop and a second output end of the first phase-locked loop respectively, and an output end of the second multiplexer is coupled to the input end of the second drive buffer circuit.

3. The chiplet according to claim 1 or 2, wherein the chiplet further comprises a silicon interposer, and the first clock mesh and the second clock mesh are disposed in the silicon interposer and are connected to each other via the silicon interposer; and
the silicon interposer is further configured to connect the first clock circuit to the second clock circuit.

4. The chiplet according to claim 1 or 2, wherein the chiplet further comprises a silicon interposer, the first clock mesh is disposed in the first die, the second clock mesh is disposed in the second die, and the first clock mesh and the second clock mesh are connected to each other via the silicon interposer; and
the silicon interposer is further configured to connect the first clock circuit to the second clock circuit.

5. The chiplet according to claim 3 or 4, wherein the first die and the second die are located on a same wafer.

6. The chiplet according to claim 5, wherein the chiplet further comprises a first sealing ring, a second sealing ring, and a dicing groove, wherein the first sealing ring is disposed between the first die and the dicing groove, and the second sealing ring is disposed between the second die and the dicing groove.

7. The chiplet according to any one of claims 3 to 6, wherein the first die is grown on the silicon interposer, or the first die is bonded to the silicon interposer via a micro bump; and/or
the second die is grown on the silicon interposer, or the second die is bonded to the silicon interposer via a micro bump.

8. The chiplet according to any one of claims 1 to 7, wherein the first die and the second die are of a heterostructure.

9. The chiplet according to claim 8, wherein either the first clock circuit or the second clock circuit further comprises a phase adjustment circuit;
a first input end of the phase adjustment circuit is coupled to a second output end of the drive buffer circuit that is located on the same die as the clock circuit;
a second input end of the phase adjustment circuit is coupled to an output end of the first clock generation circuit;
an output end of the phase adjustment circuit is coupled to the input end of the drive buffer circuit that is located on the same die as the clock circuit;
a third input end of the phase adjustment circuit of the first clock circuit is coupled to a second output end of the drive buffer circuit of the second clock circuit; and/or
a third input end of the phase adjustment circuit of the second clock circuit is coupled to a second output end of the drive buffer circuit of the first clock circuit.

10. The chiplet according to claim 9, wherein the phase adjustment circuit comprises a phase detector, a phase alignment circuit, and a phase interpolator, wherein
a first input end of the phase detector is coupled to the second output end of the drive buffer circuit that is located on the same die as the clock circuit;
an output end of the phase detector is coupled to an input end of the phase alignment circuit; a first input end of the phase interpolator is coupled to an output end of the phase alignment circuit;
a second input end of the phase interpolator is coupled to the output end of the first clock generation circuit;
an output end of the phase interpolator is coupled to the input end of the drive buffer circuit that is located on the same die as the clock circuit;
a second input end of the phase detector of the first clock circuit is coupled to the second output end of the drive buffer circuit of the second clock circuit; and/or
a second input end of the phase detector of the second clock circuit is coupled to the second output end of the drive buffer circuit of the first clock circuit.

11. The chiplet according to any one of claims 8 to 10, wherein the first clock generation circuit is further configured to receive a reference clock signal.

12. The chiplet according to any one of claims 1 to 11, wherein the first clock mesh and the second clock mesh each comprise routing in a first direction and routing in a second direction, wherein the first direction and the second direction are perpendicular to each other; and
the routing of the first clock mesh in the first direction is aligned with the routing of the second clock mesh in the first direction; or
the routing of the first clock mesh in the second direction is aligned with the routing of the second clock mesh in the second direction.

13. The chiplet according to any one of claims 1 to 12, wherein the first drive buffer circuit has a symmetrical structure, and a structure of the second drive buffer circuit is symmetrical with the structure of the first drive buffer circuit; and/or
the first clock mesh has a symmetrical structure, and the structure of the first clock mesh is symmetrical with a structure of the second clock mesh.

14. The chiplet according to claim 13, wherein the first drive buffer circuit comprises at least two layers of cascaded drive buffers, and the first drive buffer circuit comprises one input end and a plurality of output ends.

15. An electronic device, comprising the chiplet according to any one of claims 1 to 14.
